# EUROPEAN PATENT SPECIFICATION

(11) **EP 3 057 120 B1**
(45) Date of publication and mention of the grant of the patent: **25.12.2019**
(21) Application number: 16155750.9
(22) Date of filing: 15.02.2016
(51) Int. Cl.: H01J 37/32

(54) **PLASMA PRODUCING APPARATUS AND PLASMA PROCESSING METHOD**
PLASMAHERSTELLUNGSVORRICHTUNG UND PLASMAVERARBEITUNGSVERFAHREN
APPAREIL DE PRODUCTION DE PLASMA ET PROCÉDÉ DE TRAITEMENT DE PLASMA

(30) Priority: 13.02.2015 GB 201502453
(43) Date of publication of application: 17.08.2016
(73) Proprietor: SPTS Technologies Limited, Newport Gwent NP18 2TA (GB)
(72) Inventor: WILBY, Anthony, Bristol, BS37 7YJ (GB); BURGESS, Stephen, Ebbw Vale, Gwent NP23 5NA (GB); WIDDICKS, Clive, Bristol, BS9 4PP (GB); MONCRIEFF, Ian, Wickwar, GL12 8NH (GB); DENSLEY, P, Newport, Gwent NP18 2TA (GB)
(74) Representative: Wynne-Jones IP Limited

(56) References cited:
- JP-A- H1 197 422
- US-A1- 2012 273 130
- US-A1- 2013 256 129

## Description

This invention relates to a plasma producing apparatus and to associated methods of plasma processing a substrate, with particular, but by no means exclusive, reference to sputter etching.

In the semiconductor industry, it is common practice to pre-clean a semiconductor wafer prior to a process step. For example, with semiconductor wafers having a metal layer, it is common and desirable to remove material from the wafer surface by a sputter etch process in order to ensure a high quality metal/ metal interface. This is desirable to produce a repeatable low contact resistance and good adhesion. This step is normally conducted in a sputter pre-clean module which consists of a vacuum chamber surrounded by an inductive coil antenna. The substrate to be pre-cleaned is supported inside the chamber on a platen. The inductive coil antenna is wound around the outside of the chamber and one end is connecting to a RF power source through an impedance matching network. The other end of the antenna is grounded. Additionally, an RF power supply and associated impedance matching circuit is connecting to the platen in order to bias the platen. Typically, the chamber walls in the vicinity of the inductive coil antenna are made from an electrically insulating material such as quartz or ceramic so as to minimise the attenuation of the RF power coupled into the chamber.

In operation, a suitable gas (typically argon) is introduced into the chamber at a low pressure (typically around 1-10 mTorr) and RF power from the coil antenna generates an inductively coupled plasma (ICP). The platen bias acts to accelerate ions from the plasma towards the substrate. The resultant ion bombardment etches the surface of the substrate.

However, there are problems associated with a build up of material which is sputtered from a substrate and redeposited around the lid and walls of the chamber. This redeposited material can accumulate as particles which subsequently become loose. This gives rise to the potential for particles to fall onto and contaminate the substrate. Another problem is that the sputter etching of the conductive layers commonly used within the semiconductor industry, such as copper, titanium and aluminium, can lead to a build up of conductive material on the walls of the chamber. This conductive coating on the walls of the chamber has the effect of attenuating RF power coupled into the chamber by the coil antenna. The thickness of the conductive coating increases over time. The thickness of the conductive coating can increase to the point at which the sputter etch process is seriously compromised. For example, problems can be encountered with etch rate drift or a lack of etch uniformity, or problems with igniting or sustaining the plasma may be observed.

To avoid these problems, it has been necessary to perform frequent maintenance of the process module. This inevitably leads to a significant cost and tool downtime. This is highly undesirable in a production environment where throughput and efficiency are extremely important.

JPH1197422 discloses a device comprising an inductive-coupling antenna provided in a quartz chamber. EP2584583 discloses an inductively coupled plasma source for a focused charge particle beam system. US2013256129 discloses a plasma processing apparatus including a chamber and a target above the chamber.

US 2012/273130 discloses plasma processing chambers having internal Faraday shields with defined groove configurations.

The present invention, in at least some of its embodiments, addresses the above described problems. The present invention, in at least some of its embodiments, can extend the time between maintenance cleaning of the chamber whilst at least maintaining substrate to substrate process repeatability. Additionally, the present invention, in at least some of its embodiments, results in improved etch uniformity.

According to a first aspect of the invention there is provided a plasma producing apparatus for plasma processing a substrate comprising:
a chamber having an interior surface;
a plasma production device for producing an inductively coupled plasma within the chamber;
a substrate support for supporting the substrate during plasma processing; and
a Faraday shield disposed within the chamber for shielding at least part of the interior surface from material removed from the substrate by the plasma processing, and in which the Faraday shield (24) comprises a plurality of apertures;
in which the plasma production device comprises an antenna and a RF power supply configured to supply RF power to the antenna with a polarity which is alternated at a frequency of less than or equal to 1000Hz, and in which the antenna (18) is a single turn coil.

The RF power supply may supply RF power to the antenna with a polarity which is alternated at a frequency greater than or equal to 0.01Hz, preferably 0.05Hz, most preferably 0.1 Hz.

The RF power supply may supply RF power to the antenna with a polarity which is alternated at a frequency of less than or equal to 100Hz, preferably 25Hz, most preferably 10Hz.

The invention extends to the alternation of the polarity in frequency ranges comprising any combination of the above mentioned upper and lower frequency limits. For example, frequency ranges at which the polarity may be alternated include the ranges 0.1 - 1000Hz, 0.1 - 100Hz, 0.05 - 5Hz, 0.1 - 10Hz and all other combinations.

The Faraday shield may be grounded. At least a portion of the chamber may also be grounded. For example, a lid of the chamber may be grounded. The grounding of both the Faraday shield and the chamber can act to reduce deposition of material onto the chamber during plasma processing.

The Faraday shield may be a cage.

The Faraday shield comprises a plurality of apertures. The apertures may be vertically aligned slots. Typically, the antenna is horizontally disposed around the chamber, and the provision of vertically aligned slots prevents deposition of a continuous horizontal band of metal. This is advantageous, because a continuous horizontal band of metal deposited on the interior surface of the chamber causes eddy current losses which results in a reduction in etch rate.

The antenna is a single turn coil. This has been found to give rise to improve results. However, the in some examples not being part of the present invention, the antenna is a multiple turn coil.

The RF power supply may comprise a RF power source and a switch which causes the alternation of the polarity of the RF power supply to the antenna. Other elements, such as an impedance matching circuit, may be provided.

The apparatus may further comprise a substrate support electrical power supply for electrically biasing the substrate support. The substrate support electrical power supply may be a RF power supply for producing a RF bias on the substrate support.

The apparatus may be configured for sputter etching the substrate. Typically, an apparatus of this kind comprises a RF power supply for producing a RF bias on the substrate support.

The apparatus may be configured for pre-cleaning the substrate. In these embodiments, the apparatus may be provided as a module in a process tool.

The substrate may comprise a semiconductor material. The substrate may be a semiconductor wafer.

The substrate may comprise a semiconductor material having one or more metal layers formed thereon.

The invention is not specific to any particular plasma. Excellent results have been obtained using an argon plasma, but it is envisaged that the plasma may be produced using many other gases and gaseous mixtures.

According to a second aspect of the invention there is provided a method of plasma processing a substrate comprising:
producing a plasma in a chamber using a plasma production device comprising an antenna and a RF power supply for supplying RF power to the antenna; and
plasma processing the substrate;
in which:
   a Faraday shield is disposed within the chamber which shields at least part of an interior surface of the chamber from material removed from the substrate by the plasma processing, and in which the Faraday shield (24) comprises a plurality of apertures; and
   RF power is supplied to the antenna with a polarity which is alternated at a frequency of less than or equal to 1000Hz, and in which the antenna (18) is a single turn coil.

The plasma processing may be a sputter etch process. The substrate may comprise a semiconductor material having one or more metal layers formed thereon, wherein the sputter etch process removes material from the one or more metal layers.

The material removed from the substrate by the plasma processing may comprise or consist of a metal.

Herein disclosed is a plasma producing apparatus for plasma processing a substrate comprising:
a chamber having an interior surface;
a plasma production device for producing a inductively coupled plasma within the chamber; and
a substrate support for supporting the substrate during the plasma processing;
in which the plasma production device comprises an antenna and a RF power supply for supplying RF power to the antenna with a polarity which is alternated at the frequency of less than or equal to 1000Hz.

Whilst the invention has been described above, it extends to any inventive combination of the features set out in the appended claims.

Embodiments of apparatus and methods in accordance with the invention will now be described with reference to the accompanying drawings, in which:-
Figure 1 is a cross sectional view of an apparatus of the invention;
Figure 2 is a perspective view of a Faraday shield;
Figure 3 shows a RF power supply including a switch for alternating the polarity of the applied RF voltage;
Figure 4 shows etch rate of a marathon wafer etching process; and
Figure 5 shows etch non-uniformity over a marathon wafer etching process.

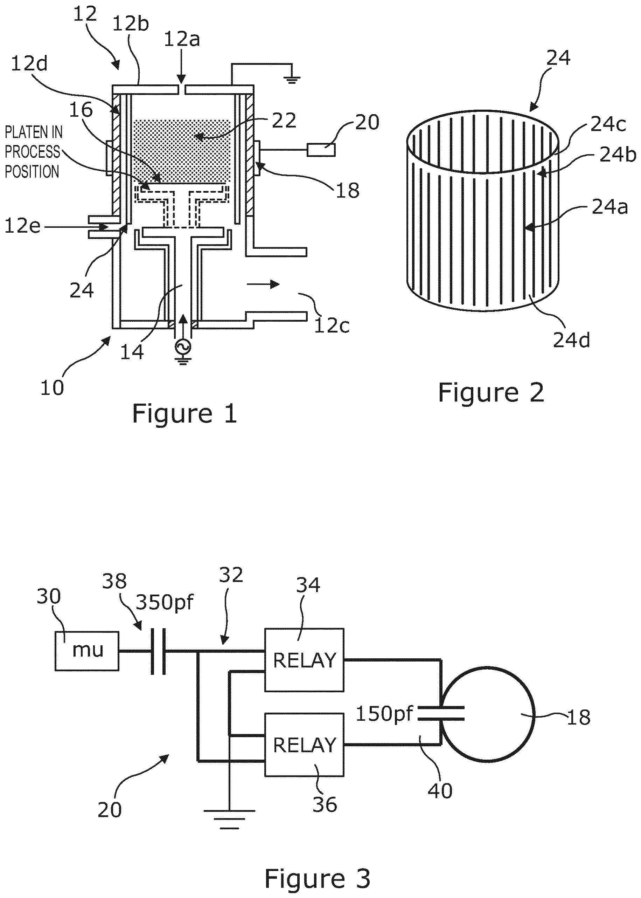

Figure 1 shows a plasma processing apparatus, depicted generally at 10, which comprises a chamber 12 and a platen 14 which is positioned in the chamber 12 and which acts as a support for a wafer 16 to be processed. The solid lines show the platen 14 in a lowered position prior to receiving the wafer, and the dotted lines show the platen 14 it its raised, in-use position. The chamber 12 comprises a gas inlet 12a positioned in a lid portion 12b and a pumping port 12c. Gases are removed from the chamber 12 via the pumping port 12c which is connected to a suitable pumping arrangement. A turbomolecular pump may be used to pump the chamber. The chamber 12 further comprises a wall portion 12d which is formed from an electrically insulating material such as quartz or ceramic and a wafer loading slot 12e. An inductive coil antenna 18 is circumferentially disposed around the wall region 12d of the chamber 12. The inductive coil antenna 18 is supplied with RF power by a RF power supply and impedance matching unit 20. A plasma 22 is created in the chamber 12 by inductively coupling RF power into the chamber 12 from the inductive coil antenna 18. The electrically insulating material of the chamber wall 12d minimises the attenuation of the RF power coupled into the chamber 12.

The apparatus 10 further comprises a Faraday shield 24 which is positioned within the chamber 12. The Faraday shield 24 is shown in more detail in Figure 2. In the embodiment shown in Figures 1 and 2, the Faraday shield is a metal cage comprising a plurality of spaced apart metal bars 24a which define vertically aligned slots 24b. The Faraday shield further comprises upper and lower rim portions 24c, 24d, respectively. Conveniently, the upper rim portion 24c may be attached to the lid portion 12b to permit the Faraday shield 24 to be grounded to the lid portion 12b. The shape of the Faraday shield generally conforms to the shape of the wall portion 12d of the chamber 12. In the embodiment shown in Figures 1 and 2, the Faraday shield 24 is of a cylindrical shape which is sized, so that, when positioned in the chamber 12, the Faraday shield 24 is spaced apart from the inner surface of the wall portion 12d.

The RF power supply 20 supplies an RF power to the coil antenna 18 by applying a RF voltage which has an associated polarity. In accordance with the invention, the polarity is alternated at low frequency. The low frequency alternation can be 1000Hz or less. Figure 3 shows an arrangement which enables the polarity of the applied RF voltage to be switched at an appropriately low frequency. Figure 3 shows the RF power supply 20 of Figure 1 in more detail. The RF power supply 20 comprises a RF power source (not shown), a RF impedance matching unit 30 and associated RF antenna circuitry. The RF power source (not shown) supplies RF energy through impedance matching unit 30 which is coupled to the coil antenna 18 through a switch 32. The switch 32 comprises first and second relays 34, 36, and first and second capacitors 38, 40. Each relay 34, 36 has an input line which carries the high RF voltage and an input line which is earthed. Each relay has an output line which is connected to a different terminal of the second capacitor 40. The antenna coil 18 has two terminals which are also each in connection to a different terminal of the second capacitor 40. It will be appreciated that the relays 34, 36 can be readily controlled so as to apply the RF power to a desired terminal of the coil antenna and to hold the other terminal of the coil antenna at ground potential. It is also possible to readily alternate the polarity of the applied RF voltage between the two terminals of the coil antenna at a desired low frequency. It will also be appreciated that many other suitable switches for achieving this end result could be implemented by the skilled reader in a straightforward manner.

In a standard prior art ICP arrangement, the coil antenna is configured such that one terminal is earthed and the other is fed the RF power. This prior art way of driving an ICP coil antenna can be characterised as asymmetric. A consequence of supplying the RF power in an asymmetric fashion is that this asymmetry is also projected onto the plasma that is produced. In particular, the end of the coil which is at a high RF potential produces in its vicinity an energetic, "hot" plasma. Conversely, the end of the coil antenna which is earthed gives rise to a plasma which is less energetic and relatively "cold". The present inventors have conducted experiments using asymmetric prior art ICP plasma production techniques in combination with a slotted Faraday shield of the type generally shown in Figure 2. It was found that the interior wall of the chamber in the vicinity of the "hot", energetic plasma (i.e., in the vicinity of the RF driven terminal of the coil antenna) was either substantially or completely free from deposition. In contrast, the interior wall of the chamber corresponding to the slots in the Faraday shield that were in the vicinity of the "cold", less energetic plasma (i.e., in the vicinity of the earthed terminal of the coil antenna) became coated with redeposited material. Without wishing to be bound by any particular theory or conjecture, it is believed that this is caused by the high voltage at one end of the coil antenna which enables a sputter-type ablation of the inside of the chamber wall by ion bombardment, i.e., by positively charged ions accelerated by strong electrical fields towards the wall of the chamber. No such mechanism exists at the ends of the earthed end of the coil antenna, and so material can build up on the interior wall in this region of the chamber. This can result in process problems such as loss of etch rate or a deterioration in etch uniformity due to a partial blocking of inductive coupling of RF power into the plasma. In addition, problems associated with the flaking of loosely adhered particulate material in this region may shorten the chamber maintenance interval. A further problem associated with the prior art technique is that driving the coil antenna asymmetrically produces a plasma that is shifted away from the centre of the chamber. This is manifest as an etch non-uniformity where the etch profile is not centred on the substrate.

The low frequency switching of the polarity taught by the present invention gives rise to a number of substantial advantages. By repeatedly driving the coil antenna using one polarity and the reverse polarity, an averaging effect is achieved with respect to the properties of the plasma. This centres the etch profile and improves etch uniformity. Experiments using 300mm wafers have been performed to demonstrate these advantages in which low frequency switching of the polarity is performed. The results are compared to experiments in which etches were performed with the coil antenna only driven with one polarity and with the coil antenna only driven with the reverse polarity. The results are shown in Table one. This clearly demonstrates that etch uniformity is improved using the low frequency switching of the polarity whilst the etch rate is at least maintained.

**Table 1**

| | Etch Rate (A/min) | Non-uniformity (1s%) |
|---|---|---|
| Coil Polarity 1 | 432 | 5.7 |
| Coil Polarity 2 | 435 | 7.1 |
| Combined Etch | 434 | 4.6 |

When the polarity is alternated in accordance with the invention, both ends of the coil antenna are alternately "hot". All points on the coil therefore experience the higher voltages which are necessary to produce a strong electric field which will facilitate sputter-type etching of the chamber by ion bombardment. It should be noted that this approach is fundamentally different to the prior art "balun" coil technique where the coil is connected to the balanced drive that operates at RF frequencies. In the case of the balun coil, a virtual ground is created and no ion etching of the chamber would occur in the vicinity of the virtual ground. With the balun technique, the switching is at very high frequency in the MHz range. At such high frequencies, the relative mobility of sputtering ions such as Ar⁺ is relatively low which means that the bombardment of the chamber interior is much reduced. This would result in an undesirable build up of redeposited material on the chamber walls. The present invention utilises much lower switching frequencies. At these low frequencies, the ions present in the plasma are able to follow the electric field and sputter-type abrasion of the chamber walls is performed which results in effective cleaning.

The Faraday shield acts as a physical shield which protects at least part of the interior of the chamber from unwanted redeposition of material. In particular, the Faraday shield can act as a sputter shield which protects against redeposition of conductive material which would otherwise attenuate the inductive coupling between the coil antenna and the plasma. The Faraday shield may be sized and positioned to be sufficiently close to the wall of the chamber that no significant line of sight exists from the interior of the chamber to the wall of the chamber behind the Faraday shield. The slots in the Faraday shield can be formed of a sufficient length that they do not significantly impinge on the electric field generated by the coil antenna. This acts to minimise the effect of the Faraday shield on the etch process. It is preferred that the slots are vertically formed so that horizontal eddy currents are prevented from circulating within the chamber. Conveniently, the Faraday shield is grounded to the chamber to minimise sputtering onto the surface of the chamber during plasma processing. In addition to the physical shielding provided by the Faraday shield, a further advantage is that the Faraday shield is effective at blocking capacitive coupling into the plasma. Capacitive coupling can contribute to a non-uniform plasma density. It is desirable that any loss of inductively coupled RF is kept to a minimum, so that there are no problems associated with striking the plasma, process etch rate or non-uniformity.

As described above, the polarity of the coil antenna is switched at low frequency in such a way as to increase the time averaged electric field at all points whilst increasing the ion bombardment of the chamber walls through the slots formed in the Faraday shield. In this way, the portion of the interior walls of the chamber which are exposed by the apertures in the Faraday shield can be effectively sputter etched so that these exposed portions of the interior walls remain substantially free from redeposition of material, in particular redeposition of metallic material. It has been observed that the low frequency switching of the polarity in combination with the use of the Faraday shield gives rise to a particularly strong plasma glow in the apertures of the Faraday shield. This strong glow is essentially uniform as a function of position within the aperture. The strength of the plasma in the apertures has the effect that any deposited material on the walls of the chamber adjacent to the apertures is removed more effectively than if there were no Faraday shield in place. This at least partly compensates for the fact that the material can be sputtered onto the walls of the chamber through the apertures in the Faraday shield.

Marathon tests were performed on 300mm wafers using an ICP sputter etch apparatus of the invention and using a prior art ICP sputter etch apparatus in which the coil antenna was driven with a single, unchanging polarity. Wafers having a 60% copper and 40% silicon dioxide surface area were etched. The ceramic portion of the chamber was inspected after each of the marathon tests. It was observed that when the coil is run prior art manner, with a single polarity, the ceramic was completely coated in redeposited material in a region close to the portion of the coil which is grounded. The area in which there was complete coating with redeposited material corresponds to approximately 17% of the total area of the ceramic portion. This redeposited material acts to block inductive coupling, allowing eddy currents to circulate, and is a potential source of particulate material which may drop onto the surface. In contrast, after marathon testing using the present invention, it was observed that the chamber ceramic was completely free from deposition at all points. This results in a stable, uniform etch that can be maintained over long periods.

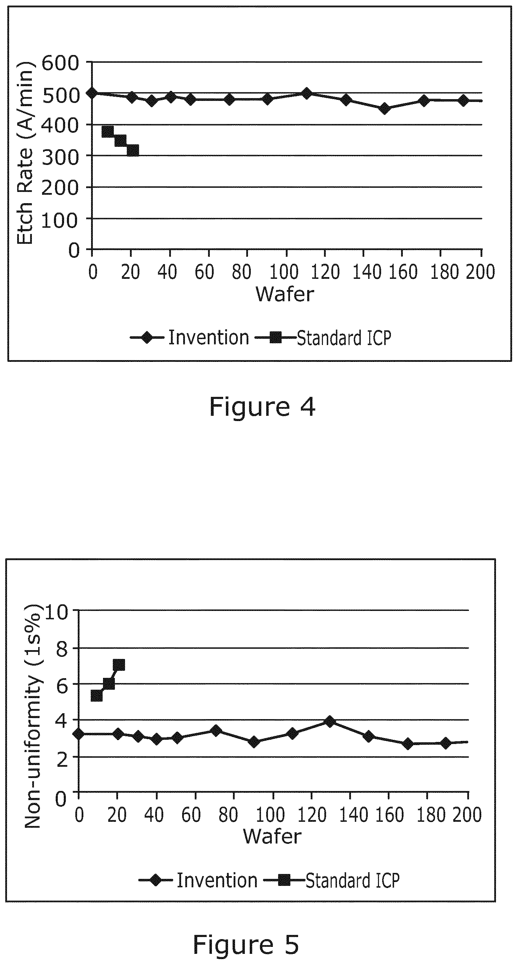

Figures 4 and 5 show quantitative results associated with the marathon tests. Figure 4 shows the etch rate obtained as a function of increasing numbers of wafers etched. Figure 5 shows etch non-uniformity as a function of increasing numbers of wafers etched. It was be seen that both the etch rate and the etch non-uniformities achieved using the present invention are remarkably superior to the prior art process. It can also be observed that only a limited number of wafer could be etched in a sequence using the prior art technique. This is because a maintenance procedure was required after 20 wafers were etched.

It is possible that a build up of redeposited material on the Faraday shield itself may become a potential source of problem particulates. This problem can be obviated or at least reduced by using a pasting technique to coat the cage with a low stress material having good adhesion. This would act to paste down any loose particulate material on the Faraday shield so the chamber maintenance can be extended.

## Claims

1. A plasma producing apparatus (10) for plasma processing a substrate (16) comprising:
a chamber (12) having an interior surface;
a plasma production device for producing an inductively coupled plasma (22) within the chamber (12);
a substrate support (14) for supporting the substrate (16) during plasma processing; and
a Faraday shield (24) disposed within the chamber (12) for shielding at least part of the interior surface from material removed from the substrate (16) by the plasma processing, and in which the Faraday shield (24) comprises a plurality of apertures;
in which the plasma production device comprises an antenna (18) and a RF power supply (20) configured to supply RF power to the antenna (18) with a polarity which is alternated at a frequency of less than or equal to 1000Hz, and in which the antenna (18) is a single turn coil.

2. A plasma producing apparatus (10) according to claim 1 in which the RF power supply (20) supplies RF power to the antenna (18) with a polarity which is alternated at a frequency of greater than or equal to 0.01 Hz, preferable 0.05Hz, most preferably 0.1 Hz.

3. A plasma producing apparatus (10) according to claim 1 or claim 2 in which the RF power supply (20) supplies RF power to the antenna (18) with a polarity which is alternated at a frequency of less than or equal to 100Hz, preferably 25Hz, most preferably 10Hz.

4. A plasma producing apparatus (10) according to any one of claims 1 to 3 in which the Faraday shield (24) is grounded.

5. A plasma producing apparatus (10) according to any previous claim in which the Faraday shield (24) is a cage.

6. A plasma producing apparatus (10) according to any previous claim in which the apertures are vertically aligned slots (24b).

7. A plasma producing apparatus (10) according to claim 6 in which the antenna (18) is horizontally disposed around the chamber (12).

8. A plasma producing apparatus (10) according to any previous claim in which the RF power supply (20) comprises a RF source and a switch which causes the alternation of the polarity of the RF power supplied to the antenna (18).

9. A plasma producing apparatus (10) according to any previous claim further comprising a substrate support electrical power supply for electrically biasing the substrate support (14).

10. A plasma producing apparatus (10) according to claim 9 in which the substrate support electrical power supply is a RF power supply for producing a RF bias on the substrate support (14).

11. A plasma producing apparatus (10) according to any previous claim configured for sputter etching the substrate (16), preferably configured for pre-cleaning the substrate (16).

12. A method of plasma processing a substrate (16) comprising:
producing a plasma (22) in a chamber (12) using a plasma production device comprising an antenna (18) and a RF power supply (20) for supplying RF power to the antenna (18); and
plasma processing the substrate (16);
in which:
a Faraday shield (24) is disposed within the chamber (12) which shields at least part of an interior surface of the chamber from material removed from the substrate (16) by the plasma processing, and in which the Faraday shield (24) comprises a plurality of apertures; and
RF power is supplied to the antenna (18) with a polarity which is alternated at a frequency of less than or equal to 1000Hz, and in which the antenna (18) is a single turn coil.

13. A method according to claim 12 in which the plasma processing is a sputter etch process, and preferably the substrate (16) comprises a semiconductor material having one or more metal layers formed thereon, wherein the sputter etch process removes material from the one or more metal layers.

## Patentansprüche

1. Plasmaerzeugungsvorrichtung (10) für die Plasmabehandlung eines Substrats (16) mit Folgendem:
einer Kammer (12) mit einer Innenfläche,
einer Plasmaerzeugungseinrichtung zum Erzeugen eines induktiv gekoppelten Plasmas (22) in der Kammer (12),
einem Substratträger (14) zum Tragen des Substrats (16) bei der Plasmabehandlung und
einer in der Kammer (12) angeordneten faradayschen Abschirmung (24) zum Abschirmen zumindest eines Teils der Innenfläche vor durch die Plasmabehandlung von dem Substrat (16) entferntem Material, wobei die faradaysche Abschirmung (24) mehrere Öffnungen aufweist,
wobei die Plasmaerzeugungseinrichtung eine Antenne (18) und eine HF-Leistungsversorgung (20) umfasst, die so konfiguriert ist, dass sie die Antenne (18) mit HF-Leistung einer Polarität versorgt, die mit einer Frequenz von maximal 1000 Hz wechselt, und wobei es sich bei der Antenne (18) um eine eingängige Spule handelt.

2. Plasmaerzeugungsvorrichtung (10) nach Anspruch 1, bei der die HF-Leistungsversorgung (20) die Antenne (18) mit HF-Leistung einer Polarität versorgt, die mit einer Frequenz von mindestens 0,01 Hz, vorzugsweise 0,05 Hz, besonders bevorzugt 0,1 Hz wechselt.

3. Plasmaerzeugungsvorrichtung (10) nach Anspruch 1 oder 2, bei der die HF-Leistungsversorgung (20) die Antenne (18) mit HF-Leistung einer Polarität versorgt, die mit einer Frequenz von maximal 100 Hz, vorzugsweise 25 Hz, besonders bevorzugt 10 Hz wechselt.

4. Plasmaerzeugungsvorrichtung (10) nach einem der Ansprüche 1 bis 3, bei der die faradaysche Abschirmung (24) geerdet ist.

5. Plasmaerzeugungsvorrichtung (10) nach einem der vorhergehenden Ansprüche, bei der es sich bei der faradayschen Abschirmung (24) um einen Käfig handelt.

6. Plasmaerzeugungsvorrichtung (10) nach einem der vorhergehenden Ansprüche, bei der es sich bei den Öffnungen um vertikal ausgerichtete Schlitze (24b) handelt.

7. Plasmaerzeugungsvorrichtung (10) nach Anspruch 6, bei der die Antenne (18) horizontal um die Kammer (12) angeordnet ist.

8. Plasmaerzeugungsvorrichtung (10) nach einem der vorhergehenden Ansprüche, bei der die HF-Leistungsversorgung (20) eine HF-Quelle und einen Schalter umfasst, der für den Wechsel der Polarität der der Antenne (18) zugeführten HF-Leistung sorgt.

9. Plasmaerzeugungsvorrichtung (10) nach einem der vorhergehenden Ansprüche, die ferner eine Substratträger-Stromversorgung zum elektrischen Vorspannen des Substratträgers (14) umfasst.

10. Plasmaerzeugungsvorrichtung (10) nach Anspruch 9, bei der es sich bei der Substratträger-Stromversorgung um eine HF-Leistungsversorgung zum Erzeugen einer HF-Vorspannung am Substratträger (14) handelt.

11. Plasmaerzeugungsvorrichtung (10) nach einem der vorhergehenden Ansprüche, die zum Sputterätzen des Substrats (16), vorzugsweise zum Vorreinigen des Substrats (16) konfiguriert ist.

12. Verfahren zum Plasmabehandeln eines Substrats (16), das Folgendes umfasst:
Erzeugen eines Plasmas (22) in einer Kammer (12) unter Verwendung einer Plasmaerzeugungseinrichtung mit einer Antenne (18) und einer HF-Leistungsversorgung (20) zum Versorgen der Antenne (18) mit HF-Leistung und
Plasmabehandeln des Substrats (16),
wobei:
eine faradaysche Abschirmung (24) in der Kammer (12) angeordnet ist, die zumindest einen Teil einer Innenfläche der Kammer vor durch die Plasmabehandlung von dem Substrat (16) entferntem Material abschirmt, und wobei die faradaysche Abschirmung (24) mehrere Öffnungen aufweist, und
die Antenne (18) mit HF-Leistung einer Polarität versorgt wird, die mit einer Frequenz von maximal 1000 Hz wechselt, und wobei es sich bei der Antenne (18) um eine eingängige Spule handelt.

13. Verfahren nach Anspruch 12, bei dem es sich bei der Plasmabehandlung um einen Sputterätzprozess handelt und das Substrat (16) vorzugsweise ein Halbleitermaterial mit einer oder mehreren darauf ausgebildeten Metallschichten umfasst, wobei der Sputterätzprozess Material von der einen oder den mehreren Metallschichten entfernt.

## Revendications

1. Appareil de production de plasma (10) servant à traiter un substrat (16) au plasma comportant :
une chambre (12) ayant une surface intérieure ;
un dispositif de production de plasma servant à produire un plasma à couplage inductif (22) à l'intérieur de la chambre (12) ;
un support de substrat (14) servant à supporter le substrat (16) au cours du traitement au plasma ; et
un écran de Faraday (24) disposé à l'intérieur de la chambre (12) servant à protéger au moins une partie de la surface intérieure contre tout matériau retiré en provenance du substrat (16) par le traitement au plasma, et dans lequel l'écran de Faraday (24) comporte une pluralité d'ouvertures ;
dans lequel le dispositif de production de plasma comporte une antenne (18) et un bloc d'alimentation de puissance radioélectrique (20) configuré pour fournir de la puissance radioélectrique à l'antenne (18) avec une polarité qui est alternée à une fréquence inférieure ou égale à 1000 Hz, et dans lequel l'antenne (18) est une bobine à un seul enroulement.

2. Appareil de production de plasma (10) selon la revendication 1, dans lequel le bloc d'alimentation de puissance radioélectrique (20) fournit de la puissance radioélectrique à l'antenne (18) avec une polarité qui est alternée à une fréquence supérieure ou égale à 0,01 Hz, de préférence de 0,05 Hz, plus encore de préférence de 0,1 Hz.

3. Appareil de production de plasma (10) selon la revendication 1 ou la revendication 2, dans lequel le bloc d'alimentation de puissance radioélectrique (20) fournit de la puissance radioélectrique à l'antenne (18) avec une polarité qui est alternée à une fréquence inférieure ou égale à 100 Hz, de préférence de 25 Hz, plus encore de préférence de 10 Hz.

4. Appareil de production de plasma (10) selon l'une quelconque des revendications 1 à 3, dans lequel l'écran de Faraday (24) est mis à la terre.

5. Appareil de production de plasma (10) selon l'une quelconque des revendications précédentes, dans lequel l'écran de Faraday (24) est une cage.

6. Appareil de production de plasma (10) selon l'une quelconque des revendications précédentes, dans lequel les ouvertures sont des fentes alignées à la verticale (24b).

7. Appareil de production de plasma (10) selon la revendication 6, dans lequel l'antenne (18) est disposée à l'horizontale autour de la chambre (12).

8. Appareil de production de plasma (10) selon l'une quelconque des revendications précédentes, dans lequel le bloc d'alimentation de puissance radioélectrique (20) comporte une source de fréquence radioélectrique et un commutateur qui entraîne l'alternance de la polarité de la puissance radioélectrique fournie à l'antenne (18).

9. Appareil de production de plasma (10) selon l'une quelconque des revendications précédentes, comportant par ailleurs un bloc d'alimentation électrique du support de substrat servant à polariser électriquement le support de substrat (14).

10. Appareil de production de plasma (10) selon la revendication 9, dans lequel le bloc d'alimentation électrique du support de substrat est un bloc d'alimentation de puissance radioélectrique servant à produire une polarisation radioélectrique sur le support de substrat (14).

11. Appareil de production de plasma (10) selon l'une quelconque des revendications précédentes, configuré à des fins de gravure par rayonnement ionique du substrat (16), configuré de préférence à des fins de pré-nettoyage du substrat (16).

12. Procédé servant à traiter un substrat (16) au plasma comportant les étapes consistant à :
produire un plasma (22) dans une chambre (12) en utilisant un dispositif de production de plasma comportant une antenne (18) et un bloc d'alimentation de puissance radioélectrique (20) servant à fournir de la puissance radioélectrique à l'antenne (18) ; et
traiter le substrat (16) au plasma ;
dans lequel :
un écran de Faraday (24) est disposé à l'intérieur de la chambre (12) qui protège au moins une partie d'une surface intérieure de la chambre contre tout matériau retiré en provenance du substrat (16) par le traitement au plasma, et dans lequel l'écran de Faraday (24) comporte une pluralité d'ouvertures ; et
de la puissance radioélectrique est fournie à l'antenne (18) avec une polarité qui est alternée à une fréquence inférieure ou égale à 1000 Hz, et dans lequel l'antenne (18) est une bobine à un seul enroulement.

13. Procédé selon la revendication 12, dans lequel le traitement au plasma est un processus de gravure par rayonnement ionique, et de préférence le substrat (16) comporte un matériau semi-conducteur ayant une ou plusieurs couches de métal formées sur celui-ci, dans lequel le processus de gravure par rayonnement ionique retire du matériau en provenance desdites une ou plusieurs couches de métal.
